(19) Europäisches Patentamt / European Patent Office / Office européen des brevets

(11) **EP 4 318 574 A1**

(12) **EUROPEAN PATENT APPLICATION**
published in accordance with Art. 153(4) EPC

(43) Date of publication:
**07.02.2024 Bulletin 2024/06**

(21) Application number: **22780897.9**

(22) Date of filing: **29.03.2022**

(51) International Patent Classification (IPC):
*H01L 23/373* (2006.01)     *C08K 7/18* (2006.01)
*C08L 63/00* (2006.01)      *C08K 3/38* (2006.01)

(52) Cooperative Patent Classification (CPC):
**C08K 3/38; C08K 7/18; C08L 63/00; H01L 23/373**

(86) International application number:
**PCT/JP2022/015374**

(87) International publication number:
**WO 2022/210686 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.03.2021 JP 2021055114**

(71) Applicant: **Mitsubishi Chemical Corporation
Chiyoda-ku
Tokyo 100-8251 (JP)**

(72) Inventors:
• **SAWAMURA, Toshiyuki
Tokyo 100-8251 (JP)**
• **TANAKA, Toshiyuki
Tokyo 100-8251 (JP)**

(74) Representative: **Hoffmann Eitle
Patent- und Rechtsanwälte PartmbB
Arabellastraße 30
81925 München (DE)**

(54) **RESIN COMPOSITION, CURED PRODUCT SHEET, COMPOSITE MOLDED BODY AND SEMICONDUCTOR DEVICE**

(57) The present invention provides a resin composition with high thermal conductivity, high insulating property, high heat resistance, and excellent handleability of a sheet; a cured product sheet; a composite molded body; and a semiconductor device. The resin composition contains an inorganic filler and a thermosetting resin, in which the amount of the inorganic filler in solid contents of the resin composition is 50% by volume or more, and the inorganic filler contains 82% by volume or more of a boron nitride filler (A), the boron nitride filler includes an aggregated filler, the thermosetting resin contains an epoxy resin having a mass-average molecular weight of 5,000 or more, a weight per epoxide equivalent (WPE) of resin components in the resin composition satisfies $100 \leq WPE \leq 300$, and a storage modulus E' of a cured product of the resin composition satisfies $1 \geq (E'$ at $270°C)/(E'$ at $30°C) \geq 0.2$.

EP 4 318 574 A1

**Description**

[Technical Field]

The present invention relates to a resin composition, and the resin composition and a cured product formed of the resin composition can be suitably used, for example, as a heat dissipation sheet for a power semiconductor device.
Priority is claimed on Japanese Patent Application No. 2021-55114, filed March 29, 2021, the content of which is incorporated herein by reference.

[Background Art]

In recent years, in power semiconductor devices used in various fields such as railways, automobiles, and general household appliances, in order to further reduce a size, reduce cost, improve efficiency, and the like, power semiconductors of the related art, which are formed of Si, are shifting to power semiconductors formed of SiC, AlN, GaN, and the like.
The power semiconductor device is generally used as a power semiconductor module in which a plurality of semiconductor devices are arranged on a common heat sink and packaged.
Various problems have been pointed out regarding practical use of such a power semiconductor device, and one of them is a problem of heat dissipation of heat generated from the device. Generally, this problem affects reliability of a power semiconductor device capable of increasing output and increasing density by operating at a high temperature. There is a concern that heat generation accompanied with device switching reduces the reliability.
In recent years, particularly in the fields of electricity and electronics, heat generation due to high density of integrated circuits and high voltage due to high output have become major problems, and how to dissipate the heat and how to maintain a high level of insulating property are urgent issues.
As one method for solving this problem, a ceramic substrate having high thermal conductivity, such as an alumina substrate and an aluminum nitride substrate, is used as a heat dissipation substrate on which the power semiconductor device is mounted. However, the ceramic substrate has drawbacks such as being easily broken by an impact, being difficult to make a thin film, and being difficult to be reduced the size thereof.
In order to solve the above-described problems with regard to the ceramic substrate, many studies have been made on a heat dissipation sheet which has favorable thermal conductivity and excellent insulating property. In particular, attempts have been made to obtain a heat dissipation resin sheet in which a filler is mixed with a resin, which satisfies thermal conductivity and insulating property at a high level. Various oxides and nitrides have been used as the filler contained in such a heat dissipation resin sheet, and many studies have been carried out (for example, Patent Document 1).
As the filler contained in the heat dissipation sheet, attempts have been made to use hexagonal boron nitride. The hexagonal boron nitride is generally a thin plate-like crystal, and a thermal conductivity in a planar direction of the thin plate is high, but a thermal conductivity in a thickness direction of the thin plate low. In addition, when the thin plate-like boron nitride is blended into the heat dissipation sheet, the sheet is aligned in parallel with a sheet surface when forming a sheet. Therefore, thermal conductivity in a thickness direction of the sheet has never been improved.
As a material which increases the thermal conductivity in the thickness direction of the sheet, an aggregated boron nitride filler is an exemplary example. It has been widely known that the thermal conductivity in the thickness direction of the sheet can be improved by using the aggregated boron nitride filler. In particular, the present inventors have previously developed an aggregated boron nitride filler having a card-house structure (for example, refer to Patent Document 2). Furthermore, the present inventors have developed an aggregated boron nitride filler having a card-house structure which has a relatively large average particle diameter and does not collapse even in a case where pressure is applied (for example, refer to Patent Document 3). Since these aggregated boron nitride fillers secure a heat conduction path due to the card-house structure, when the aggregated boron nitride filler is contained in the heat dissipation sheet, the thermal conductivity in the thickness direction of the sheet is excellent. In addition, in the aggregated boron nitride filler, boron nitride particles are aggregated without using a separate binder. Therefore, even in a case where an external force is applied when forming the sheet, the card-house structure does not easily collapse and the heat conduction path is maintained, heat can be dissipated in the thickness direction of the sheet, and excellent thermal conductivity can be achieved (for example, refer to Patent Documents 4 and 5).
In addition, as a molding method for increasing the thermal conductivity in the thickness direction of the sheet, a method for increasing the thermal conductivity by bringing the aggregated boron nitride fillers in the sheet into surface-contact with each other is known (for example, refer to Patent Document 6).

[Citation List]

[Patent Documents]

[Patent Document 1]
Japanese Unexamined Patent Application, First Publication No. 2013-089670
[Patent Document 2]
Japanese Unexamined Patent Application, First Publication No. 2015-006985
[Patent Document 3]
Japanese Unexamined Patent Application, First Publication No. 2016-135730
[Patent Document 4]
PCT International Publication No. 2015/119198
[Patent Document 5]
Japanese Unexamined Patent Application, First Publication No. 2017-036415
[Patent Document 6]
PCT International Publication No. 2019/189746

[Summary of Invention]

[Technical Problem]

However, the present inventor has found that, in the compositions disclosed in Patent Documents 2 to 6 described above, when the amount of the filler is increased to increase the thermal conductivity, remaining voids in the sheet may cause a problem of reduced insulating property. In addition, it has been also found that, in the composition disclosed in Patent Document 1, both heat resistance and handleability of the sheet before curing cannot be achieved. An object of the present invention is to provide a resin composition with high thermal conductivity, high insulating property, preferably high heat resistance, and excellent handleability of a sheet; a cured product sheet; a composite molded body; and a semiconductor device.

[Solution to Problem]

As a result of repeated studies to achieve the above-described objects, the present inventor has found that the above-mentioned problems can be solved by using a resin composition containing a specific filler and a resin.
The present invention has been achieved based on such findings, and the gist of the present invention is as follows.
[1] A resin composition comprising:

an inorganic filler; and
a thermosetting resin,
wherein the amount of the inorganic filler in solid contents of the resin composition is 50% by volume or more,
and the inorganic filler contains 82% by volume or more of a boron nitride filler (A),
the boron nitride filler (A) includes an aggregated filler,
the thermosetting resin contains an epoxy resin having a mass-average molecular weight of 5,000 or more,
a weight per epoxide equivalent (WPE) of resin components in the resin composition satisfies $100 \leq WPE \leq 300$, and
a storage modulus E' of a cured product of the resin composition satisfies $1 \geq (E'\text{ at }270°C)/(E'\text{ at }30°C) \geq 0.2$.

[2] The resin composition according to [1],
wherein a rigidity G' of a cured product of the resin components satisfies $1 \geq (G'\text{ at }200°C)/(G'\text{ at }30°C) > 0.1$.
[3] The resin composition according to [1] or [2],
wherein the storage modulus E' of the cured product of the resin composition is $1 \times 10^8$ Pa or more at 30°C.
[4] The resin composition according to any one of [1] to [3],

wherein the inorganic filler contains an inorganic filler (B) other than the boron nitride filler (A),

the inorganic filler (B) contains spherical particles having an average particle diameter of 0.1 $\mu$m or more and 1 $\mu$m or less, and

the proportion of the spherical particles having an average particle diameter of 0.1 $\mu$m or more and 1 $\mu$m or less in the inorganic filler is 2.4% by volume or less.

[5] The resin composition according to any one of [1] to [4],
wherein the thermosetting resin has an epoxy resin having a mass-average molecular weight of 10,000 or more and an epoxy resin having a mass-average molecular weight of 600 or less.
[6] The resin composition according to [5],
wherein the epoxy resin having a mass-average molecular weight of 600 or less includes three or more epoxy groups in one molecule.
[7] The resin composition according to any one of [1] to [6],
wherein the inorganic filler (B) is a metal oxide and/or a non-metal oxide.
[8] A cured product sheet formed of the resin composition according to any one of [1] to [7].
[9] A composite molded body comprising:

a cured product part comprising the cured product sheet according to [8]; and
a metal part.

[10] A semiconductor device comprising:
the composite molded body according to [9].

[Advantageous Effects of Invention]

With the resin composition according to the aspect of the present invention, which contains a specific filler and a resin, it is possible to provide a cured product sheet, a composite molded body, and a semiconductor device with high thermal conductivity, high insulating property, and high heat resistance while maintaining handleability of an uncured sheet.

[Description of Embodiments]

Hereinafter, embodiments of the present invention will be described in detail, but the present invention is not limited to the following embodiments, and can be variously modified and implemented within the scope of the gist thereof.

[Resin composition]

The resin composition according to the embodiment of the present invention contains an inorganic filler and a thermosetting resin, and refers to a composition in a state before curing in a molding pressurization step or the like. For example, a slurry-like resin composition to be subjected to a coating step described later, a sheet which has undergone the coating step, a sheet which has undergone a step such as coating and drying, and the like are exemplary examples.
The reasons why the resin composition according to the embodiment of the present invention exhibits the above-described effects include the following.

1) With regard to the high thermal conductivity, since the amount of the inorganic filler is 50% by volume or more and the inorganic filler contains 82% by volume or more of the boron nitride filler (A), it is possible to secure a sufficient heat conduction path in a thickness direction of a sheet after the sheet is cured, and increase the thermal conductivity.
2) With regard to the high insulating property, since the WPE of the resin components satisfies $100 \leq WPE \leq 300$, it is possible to reduce voids in a cured product sheet by improving resin fluidity, and to improve dielectric withstand voltage by improving crosslinking density. Accordingly, it is possible to achieve the high insulating property of a cured product sheet formed of the resin composition. In particular, when the proportion of the boron nitride filler which is an aggregated filler is high, the voids are likely to be generated, and it is effective to set the WPE of the resin components within the above-described range. In addition, when pressure is reduced after pressurizing the sheet, so-called spring back in which the voids are generated again may occur. When the WPE of the resin components is within the range, it is considered that suppression of the spring back can be achieved by improving the crosslinking density.
3) With regard to the high heat resistance, since the change in storage modulus E' of the cured product of the resin composition is controlled within a specific range, it is possible to suppress deformation of the cured product sheet at high temperatures, increase a mechanical strength of the cured product, and improve the heat resistance.

4) With regard to the handleability of the sheet, since the resin having a molecular weight of 5,000 or more is contained, it is possible to improve film-forming property of the sheet before curing, and improve the handleability of the uncured sheet.

The ratio of the storage modulus E' of the cured product of the resin composition according to the embodiment of the present invention at each temperature of 270°C and 30°C ((E' at 270°C)/(E' at 30°C)) satisfies 1 ≥ (E' at 270°C)/(E' at 30°C) >_ 0.20. It is preferably 0.99 ≥ (E' at 270°C)/(E' at 30°C), and more preferably 0.95 ≥ (E' at 270°C)/(E' at 30°C). In addition, it is preferably (E' at 270°C)/(E' at 30°C) ≥ 0.22, more preferably (E' at 270°C)/(E' at 30°C) >_ 0.25, and still more preferably (E' at 270°C)/(E' at 30°C) >_ 0.28. Within these ranges, it tends to be capable of maintaining interfacial adhesive strength by maintaining elastic modulus at high temperatures, and of suppressing cracks by reducing thermal stress.

The cured product of the resin composition is obtained by laminating molded sheets of the resin composition according to the embodiment of the present invention, adjusting a sample thickness to 0.1 to 1.0 mm, and performing heat curing, in which in the heating step, the laminate is cured until an exothermic peak obtained when the temperature is raised from 40°C to 250°C at a rate of 10 °C/min by a differential scanning calorimeter (DSC) is 10 J/g or less.

In addition, the measurement of E' at 30°C and 270°C is performed by cutting the cured product which is obtained by laminating molded sheets of the resin composition, adjusting a sample thickness to 0.1 to 1.0 mm, and performing heat curing into strips with a width of 4 mm, and then performing a dynamic viscoelasticity test in a tensile mode.

A method for adjusting the ratio of the storage modulus E' of the cured product of the resin composition at each temperature of 270°C and 30°C to the above-described range is not particularly limited, and improving the crosslinking density by lowering the WPE of the resin components, increasing a glass transition temperature (Tg) (hereinafter, the glass transition temperature may be referred to as Tg) by blending a resin having a high Tg, increasing the amount of the filler blended, and the like are exemplary examples.

The storage modulus E' is not particularly limited as long as the ratio of the storage modulus E' of the cured product of the resin composition at each temperature of 270°C and 30°C is within the above-described range.

The storage modulus E' at 30°C is preferably $1 \times 10^8$ Pa or more, more preferably $5 \times 10^8$ Pa or more, and still more preferably $1 \times 10^9$ Pa or more. In addition, it is preferably $1 \times 10^{12}$ Pa or less, and more preferably $5 \times 10^{11}$ Pa or less. Within these ranges, an effect of increasing the mechanical strength of the cured product at room temperature tends to be obtained.

The storage modulus E' at 270°C is preferably $2 \times 10^7$ Pa or more, more preferably $5 \times 10^7$ Pa or more, and still more preferably $1 \times 10^8$ Pa or more. In addition, it is preferably $1 \times 10^{11}$ Pa or less, and more preferably $5 \times 10^{10}$ Pa or less. Within these ranges, it tends to be capable of maintaining interfacial adhesive strength by maintaining elastic modulus at high temperatures, and of suppressing cracks by reducing thermal stress.

<Thermosetting resin>

The thermosetting resin according to the present invention contains an epoxy resin having a mass-average molecular weight of 5,000 or more. The resin having a mass-average molecular weight of 5,000 or more may include a thermosetting resin other than the epoxy resin or an epoxy resin having a different molecular weight, as long as it includes the epoxy resin.

The thermosetting resin contained in the resin composition according to the embodiment of the present invention is not particularly limited as long as it can be cured in the presence of a curing agent or a thermosetting catalyst to obtain a cured product.

As the thermosetting resin, specifically, an epoxy resin, a phenol resin, a polycarbonate resin, an unsaturated polyester resin, a urethane resin, a melamine resin, a urea resin, and the like are exemplary examples. Among these, from the viewpoint of viscosity, heat resistance, hygroscopicity, and handleability, an epoxy resin is preferable. As the epoxy resin, an epoxy group-containing silicon compound, an aliphatic epoxy resin, a bisphenol A or F type epoxy resin, a novolak type epoxy resin, a biphenyl type epoxy resin, an alicyclic epoxy resin, a glycidyl ester type epoxy resin, a polyfunctional epoxy resin, a polymer type epoxy resin, and the like are exemplary examples.

(Epoxy resin)

The epoxy resin is a general term for compounds having one or more oxylan rings (epoxy groups) in a molecule. In addition, the oxylan ring (epoxy group) included in the epoxy resin may be either an alicyclic epoxy group or a glycidyl group, but from the viewpoint of reaction rate or heat resistance, a glycidyl group is more preferable.

The epoxy resin used in the present invention contains an epoxy resin having a mass-average molecular weight of 5,000 or more. The mass-average molecular weight of the epoxy resin is preferably 10,000 or more, more preferably 20,000 or more, and still more preferably 30,000 or more. In addition, as the upper limit thereof, 100,000 or less is an exemplary example. Within these ranges, the film-forming property of the resin composition tends to be improved, and the handleability of the uncured sheet tends to be improved. In addition, improving the film-forming property has an effect of bonding the fillers to each other at the stage of the uncured sheet, and thus the voids are less likely to be generated.

The mass-average molecular weight of the epoxy resin according to the present invention is a polystyrene-equivalent value measured by gel permeation chromatography. In addition, the weight per epoxide equivalent is defined as "mass of the epoxy resin including 1 equivalent of the epoxy group", and can be measured according to JIS K 7236.

Furthermore, it is preferable that the thermosetting resin according to the present invention includes an epoxy resin having a molecular weight of 600 or less. The molecular weight thereof is more preferably 550 or less, and still more preferably 500 or less. In addition, the lower limit thereof is not particularly limited, but is 100 or more. When including an epoxy resin within these ranges, the voids due to the improvement in resin fluidity tend to be reduced.

In addition, the weight per epoxide equivalent (WPE) of the resin components of the resin composition according to the present invention is $100 \leq WPE \leq 300$. When the resin composition according to the embodiment of the present invention contains the inorganic filler and a solvent, the resin components here are components excluding the solvent. The lower limit of the weight per epoxide equivalent (WPE) is preferably 110 or more, and more preferably 120 or more. In addition, the upper limit of the weight per epoxide equivalent (WPE) is preferably 290 or less, and more preferably 270 or less. Within these ranges, effects of suppressing the deformation of the cured product at high temperatures and improving the mechanical strength of the cured product by improving the crosslinking density tend to be obtained.

Here, a method for measuring the weight per epoxide of the resin components is not particularly limited, and the weight per epoxide equivalent can be measured by a potential difference titration method or the like.

The epoxy resin used in the present invention may be an aromatic oxylan ring (epoxy group)-containing compound. As specific examples thereof, a bisphenol type epoxy resin obtained by glycidylating bisphenols such as bisphenol A, bisphenol F, bisphenol AD, bisphenol S, tetramethyl bisphenol A, tetramethyl bisphenol F, tetramethyl bisphenol AD, tetramethyl bisphenol S, and tetrafluoro bisphenol A; an epoxy resin obtained by glycidylating divalent phenols such as a biphenyl type epoxy resin, dihydroxynaphthalene, and 9,9-bis(4-hydroxyphenyl) fluorene; an epoxy resin obtained by glycidylating trisphenols such as 1,1,1-tris(4-hydroxyphenyl)methane; an epoxy resin obtained by glycidylating tetrakisphenols such as 1,1,2,2-tetrakis(4-hydroxyphenyl)ethane; a novolak type epoxy resin obtained by glycidylating novolaks such as phenol novolak, cresol novolak, bisphenol A novolak, and brominated bisphenol A novolak; and the like are exemplary examples.

The epoxy resin contained in the resin composition according to the embodiment of the present invention is not particularly limited, and for example, one kind or two or more kinds selected from various bisphenol type epoxy resins obtained by glycidylating bisphenols such as bisphenol A type epoxy resin and bisphenol F type epoxy resin; various biphenyl type epoxy resins obtained by glycidylating biphenyls; epoxy resins obtained by glycidylating aromatic compounds having two hydroxyl groups, such as dihydroxynaphthalene and 9,9-bis(4-hydroxyphenyl)fluorene; epoxy resins obtained by glycidylating trisphenols such as 1,1,1-tris(4-hydroxyphenyl)methane; epoxy resins obtained by glycidylating tetrakisphenols such as 1,1,2,2-tetrakis(4-hydroxyphenyl)ethane; novolak type epoxy resins obtained by glycidylating novolaks such as phenol novolak, cresol novolak, bisphenol A novolak, and brominated bisphenol A novolak; and silicone-containing epoxy resins are preferable.

In particular, as the epoxy resin having a mass-average molecular weight of 5,000 or more, a bisphenol type epoxy resin or a biphenyl type epoxy resin is preferable because heat resistance and adhesiveness of the sheet tend to be improved.

In addition, as the epoxy resin having a mass-average molecular weight of 600 or less, a polyfunctional epoxy resin including three or more epoxy groups (oxylan rings) in one molecule is preferable. As these epoxy resins, EX321L, DLC301, and DLC402 manufactured by Nagase ChemteX Corporation, and BATG and PETG manufactured by Showa Denko K.K., and the like are exemplary examples. By using these resins, effects of improving the elastic modulus of the cured product by improving the crosslinking density, reducing the voids in the cured product sheet by improving the resin fluidity, and the like tend to be obtained.

(Content)

When containing a solvent, in 100% by volume of the resin composition according to the embodiment of the present invention (solid contents) excluding the solvent, the resin composition according to the embodiment of the present invention preferably contains 5% to 50% by volume, particularly 10% to 40% by volume of the thermosetting resin. When the amount of the thermosetting resin component is the above-described lower limit or more, moldability is favorable, and when being the above-described upper limit or less, the amounts of other components can be ensured and the thermal conductivity can be improved.

In addition, when the resin composition according to the embodiment of the present invention contains the inorganic filler and a thermosetting catalyst described later, it is preferable that the main component in components excluding the thermosetting catalyst is the epoxy resin. Here, the main component refers to the most abundant component.

The proportion of the epoxy resin in 100% by mass of the thermosetting resin contained in the resin composition according to the embodiment of the present invention is not particularly limited, but is preferably 20% by mass or more and more preferably 30% by mass or more. In addition, the upper limit value thereof is 100% by mass, and all of the thermosetting resin may be the epoxy resin. When the proportion of the epoxy resin is within the above-described range, the mechanical strength of the cured product sheet tends to be improved and favorable adhesiveness to a metal adherend tends to be exhibited.

In addition, in the epoxy resin included in the thermosetting resin according to the present invention, the epoxy resin having a mass-average molecular weight of 5,000 or more is contained in an amount of preferably 5% by mass or more, and more preferably 10% by mass or more. In addition, it is preferable to contain 29% by mass or less, and more preferable to contain 27% by mass or less. Within these ranges, the effects of improving the film-forming property of the resin composition and improving the handleability of the uncured sheet tend to be exhibited.

In the epoxy resin included in the thermosetting resin according to the present invention, the epoxy resin having a mass-average molecular weight of 600 or less is contained in an amount of preferably 30% by mass or more, and more preferably 40% by mass or more. In addition, it is preferable to contain 90% by mass or less, and more preferably 80% by mass or less. Within these ranges, effects of improving the elastic modulus of the cured product sheet by improving the crosslinking density and reducing the voids in the cured product sheet by improving the resin fluidity tend to be exhibited.

The ratio of a rigidity G' of a cured product of the resin components according to the present invention at each temperature of 200°C and 30°C is preferably $1 \geq$ (G' at 200°C)/(G' at 30°C) $> 0.1$. It is more preferably $0.9 \geq$ (G' at 200°C)/(G' at 30°C), and still more preferably $0.8 \geq$ (G' at 200°C)/(G' at 30°C). In addition, the lower limit value thereof is more preferably (G' at 200°C)/(G' at 30°C) $\geq 0.2$, and still more preferably (G' at 200°C)/(G' at 30°C) $\geq 0.25$. Within these ranges, effects of improving the filler interfacial adhesive strength at high temperatures by suppressing resin softening and improving interfacial adhesive strength with the metal adherend by improving the mechanical strength of the cured product tend to be obtained.

The cured product of the resin components is the same as the cured product described in E' above.

In addition, as a method for measuring G' at 30°C and 200°C, a sheet molded product of the resin composition containing no inorganic filler is cured by heating with a rheometer under the conditions of a strain of 0.3%, a frequency of 1 Hz, and a gap of 0.5 mm.

A method for adjusting the ratio of the rigidity G' of the cured product of the resin composition at each temperature of 200°C and 30°C to the above-described range is not particularly limited, and improving the crosslinking density by lowering the WPE of the resin components, improving the crosslinking density by adjusting the amount of the curing agent, and the like are exemplary examples.

<Inorganic filler>

When containing a solvent, the resin composition according to the embodiment of the present invention contains 50% by volume or more of the inorganic filler in 100% by volume of the resin composition according to the embodiment of the present invention (solid contents), excluding the solvent, and contains 82% by volume or more of a boron nitride filler (A) in 100% by volume of the inorganic filler.

When containing a solvent, the proportion of the inorganic filler in 100% by volume of the resin composition according to the embodiment of the present invention excluding the solvent is preferably 51% by volume or more, and more preferably 53% by volume or more. In addition, the upper limit thereof is preferably 90% by volume or less, and more preferably 85% by volume or less.

In addition, the proportion of the boron nitride filler (A) in 100% by volume of the inorganic filler is preferably 83% by volume or more, and more preferably 85% by volume or more. In addition, the upper limit thereof is not particularly limited, and the boron nitride filler (A) may be 100% by volume.

When the inorganic filler is within the above-described range, the heat conduction path between the inorganic fillers can be secured, and high thermal conductivity can be exhibited.

As an inorganic filler other than the boron nitride filler (A), fillers including at least one kind of particles selected from the group consisting of metal carbide, metal oxide, and metal nitride are exemplary examples.

As an example of the metal carbide, synthetic magnesite is an exemplary example. As examples of the metal oxide, aluminum oxide (alumina), magnesium oxide, silicon oxide, calcium oxide, zinc oxide, yttrium oxide, zirconium oxide, cerium oxide, ytterbium oxide, sialon (ceramics composed of silicon, aluminum, oxygen, and nitrogen), and the like are exemplary examples. As examples of the metal nitride, aluminum nitride, silicon nitride, and the like are exemplary examples.

In addition, a shape of the inorganic filler is not limited, and the inorganic filler may be in a form of particles, spheres, whiskers, fibers, plates, or an aggregate thereof. Inorganic fillers of the above-described types and shapes may be used in combination.

Among the above, in order to improve the thermal conductivity of the cured product sheet according to the present invention and control coefficient of linear expansion, it is preferable to contain a large amount of aggregated inorganic filler. By containing the aggregated inorganic filler, in a molding pressurization step, the aggregated inorganic fillers are deformed by contacting each other, so that surface contact tends to form more heat conduction paths, thereby obtaining high thermal conductivity. An aggregated form of the aggregated inorganic filler can be confirmed by a scanning electron microscope (SEM).

(Aggregated inorganic filler)

As the aggregated inorganic filler, an electrically insulating filler can be used, the above-described fillers including at least one kind of particles selected from the group consisting of metal carbide, metal oxide, and metal nitride are exemplary examples.

Since the insulating property is required for power semiconductor applications, the aggregated inorganic filler preferably includes an inorganic compound having excellent insulating property, in which a volume resistivity is $1 \times 10^{13}$ $\Omega \cdot cm$ or more, particularly $1 \times 10^{14}$ $\Omega \cdot cm$ or more. Among these, oxides and nitrides are preferable because electrical insulating property of the cured product sheet is sufficient. As such an aggregated inorganic filler, more specifically, alumina ($Al_2O_3$, volume resistivity: $1 \times 10^{14}$ $\Omega \cdot cm$), aluminum nitride (AlN, volume resistivity: $1 \times 10^{14}$ $\Omega \cdot cm$), boron nitride (BN, volume resistivity: $1 \times 10^{14}$ $\Omega \cdot cm$), silicon nitride ($Si_3N_4$, volume resistivity: $1 \times 10^{14}$ $\Omega \cdot cm$), silica ($SiO_2$, volume resistivity: $1 \times 10^{14}$ $\Omega \cdot cm$), and the like are exemplary examples. Among these, alumina, aluminum nitride, boron nitride, or silica is preferable, and alumina or boron nitride is particularly preferable.

The aggregated inorganic filler may be surface-treated with a surface treatment agent. As the surface treatment agent, a known surface treatment agent can be used.

These aggregated inorganic fillers may be used alone as one kind thereof, or may be mixed and used in combination of two or more optional kinds thereof at optional ratio. In particular, in the present invention, there is no particular limitation on the method or degree of aggregation of the aggregated inorganic filler.

(Boron nitride aggregated particles)

In the present invention, the boron nitride filler (A) includes aggregated particles. Boron nitride has high thermal conductivity but is scaly, and has heat conduction in a planar direction but high heat resistance in a direction perpendicular to the plane. It is preferable to use aggregated particles in which scales are collected and aggregated into a spherical shape in order to improve handleability. When the boron nitride aggregated particles are layered like cabbages, it is preferable that the boron nitride aggregated particles are aligned in the planar direction and that has more favorable heat conduction in a circumferential direction of the aggregated particles. On the other hand, it is preferable that the boron nitride aggregated particles have a card-house structure. The "card-house structure" is, for example, described in Ceramics 43 No. 2 (published by The Ceramic Society of Japan in 2008), and is a structure in which plate-shaped particles are not oriented and are intricately laminated.

More specifically, the boron nitride aggregated particles having the card-house structure are an aggregate of boron nitride primary particles, and are boron nitride aggregated particles having a structure in which a plane portion and an end surface portion of the primary particle are in contact with each other to form, for example, a T-shaped associated body.

As the boron nitride aggregated particles used in the present invention, the above-described boron nitride aggregated particles having the card-house structure are particularly preferable, and by using the boron nitride aggregated particles having the card-house structure, the thermal conductivity can be further increased.

A modified Mohs hardness of the boron nitride aggregated particles is not particularly limited, but is preferably 5 or less. The lower limit thereof is not particularly limited, but is, for example, 1 or more.

When the modified Mohs hardness is 5 or less, particles dispersed in the resin composition are likely to come into surface contact with each other, a heat conduction path between the particles is formed, and the heat conduction of the cured product sheet tends to be improved.

A volume-average particle diameter of the boron nitride aggregated particles is not particularly limited, but is preferably 10 $\mu m$ or more and more preferably 15 $\mu m$ or more. In addition, it is preferably 100 $\mu m$ or less, and more preferably 90 $\mu m$ or less. When the volume-average particle diameter is 10 $\mu m$ or more, the number of particles is relatively large in the resin composition and the cured product formed of the resin composition, so that the heat resistance may be increased by increasing an interface between particles, and the composite molded body may have low thermal conductivity. In addition, when the volume-average particle diameter is the above-described upper limit value or less, surface smoothness of the cured product formed of the resin composition tends to be obtained.

Here, the volume-average particle diameter of the boron nitride aggregated particles means the particle diameter at which the cumulative volume reaches 50% when plotting a cumulative curve with the volume of the powder used for measurement taken as 100%. As a measurement method, a wet measurement method for performing measurement with respect to a sample obtained by dispersing the aggregated particles in a pure water medium containing sodium hexametaphosphate as a dispersion stabilizer using a laser diffraction/scattering particle size distribution measurement device or the like, and a dry measurement method for performing measurement using "Morphologi" manufactured by Malvern are exemplary examples. The same applies to a spherical filler described later.

In the present invention, the "volume-average particle diameter" is also simply referred to as "average particle diameter".

<Amount of boron nitride aggregated inorganic filler>

The amount of the boron nitride aggregated inorganic filler in the inorganic filler according to the present invention is preferably 30% by mass or more, more preferably 40% by mass or more, and particularly preferably 50% by mass or more in 100% by mass of the inorganic filler. In addition, the upper limit thereof is not particularly limited, and may be 100% by mass.

When the amount of the boron nitride aggregated inorganic filler is the above-described lower limit value or more, the effect of improving the thermal conductivity and the effect of controlling the coefficient of linear expansion by containing the boron nitride aggregated inorganic filler tend to be sufficiently obtained.

The resin composition according to the embodiment of the present invention may contain an inorganic filler (B) other than the boron nitride filler (A). As the inorganic filler (B), fillers including at least one kind of particles selected from the group consisting of metal carbide, metal oxide, non-metal oxide, and metal nitride are exemplary examples. Among these, the inorganic filler (B) is preferably a metal oxide and/or a non-metal oxide.

As an example of the metal carbide, synthetic magnesite is an exemplary example. As examples of the metal oxide, aluminum oxide (alumina), magnesium oxide, silicon oxide, calcium oxide, zinc oxide, yttrium oxide, zirconium oxide, cerium oxide, ytterbium oxide, sialon (ceramics composed of silicon, aluminum, oxygen, and nitrogen), and the like are exemplary examples. As examples of the non-metal oxide, silicon dioxide and the like are exemplary examples. As examples of the metal nitride, aluminum nitride and the like are exemplary examples.

In addition, a shape of the inorganic filler (B) is not limited, and the inorganic filler may be in a form of particles, spheres, whiskers, fibers, plates, or an aggregate thereof. Inorganic fillers (B) of the above-described types and shapes may be used in combination.

When using the boron nitride filler (A) and the inorganic filler (B) in combination, the proportion of the boron nitride filler (A) and the inorganic filler (B) in the inorganic filler contained in the resin composition is not particularly limited, but from the viewpoint of increasing thermal conductivity by improving a filling rate of the filler, the proportion thereof is preferably 99.5:0.5 to 10:90 and more preferably 97:3 to 15:85 in terms of volume ratio.

As the inorganic filler (B), spherical particles (hereinafter, may be referred to as an inorganic filler (B1)) containing particles having an average particle diameter in a range of 0.1 $\mu$m or more and 1 $\mu$m or less may be contained.

In addition, the proportion of the particles having an average particle diameter in a range of 0.1 $\mu$m or more and 1 $\mu$m or less, which are contained in the inorganic filler (B1) of the inorganic filler (B), is preferably 2.4% by volume or less, more preferably 2.3% by volume or less, and still more preferably 2.0% by volume or less with respect to 100% by volume of the inorganic filler contained in the resin composition according to the embodiment of the present invention. In addition, the lower limit thereof is not limited, and may be 0% by volume. When the proportion of the spherical particles having an average particle diameter in a range of 0.1 $\mu$m or more and 1 $\mu$m or less is within the above-described range, effects of void reduction and high heat dissipation due to improvement of filler fluidity tend to be obtained.

The average particle diameter in the present invention is an average particle diameter obtained from a particle size distribution measurement result of a volume average, which is measured by a laser diffraction type particle size distribution measurement device.

Here, the "spherical" may be anything that is generally recognized as a spherical shape, and for example, an average circularity of 0.4 or more may be regarded as the spherical shape, or an average circularity of 0.6 or more may be regarded as the spherical shape. The upper limit of the average circularity is generally 1. The circularity can be measured by image-processing a projected image, and can be measured by, for example, FPIA series of Sysmex Corporation.

In the resin composition according to the embodiment of the present invention, an organic filler may be used in combination in addition to the above-described inorganic filler. As the organic filler, either a thermoplastic resin filler or a thermosetting resin filler may be used. As specific examples thereof, acrylic resin particles, epoxy resin particles, nylon resin particles, polyester resin particles, polystyrene resin particles, silicone resin particles, and the like are exemplary examples. The organic filler may be used alone as one kind thereof, or a combination of two or more kinds thereof may be used.

The upper limit of an average particle diameter of the above-described organic filler is preferably 100 $\mu$m or

less, more preferably 50 μm or less, and still more preferably 30 μm or less. By setting these upper limit values or less, it is possible to produce heat-dissipating insulating sheets having various thicknesses without a risk of a decrease in thermal conductivity. The average particle diameter of the organic filler is also the average particle diameter obtained from a particle size distribution measurement result of a volume average, which is measured by a laser diffraction type particle size distribution measurement device.

(Other components)

The resin composition according to the embodiment of the present invention is not particularly limited as long as it contains the inorganic filler and the thermosetting resin as described above, and may contain other components as long as the effects of the present invention are not impaired. As the other components, a thermosetting catalyst, a curing agent, a solvent, a surface treatment agent for improving interfacial adhesive strength between the inorganic filler and the resin composition, which is optionally used when producing the cured product sheet using the resin composition, such as a silane coupling agent, an insulating carbon component such as a reducing agent, a viscosity modifier, a dispersant, a thixotropy-imparting agent, a flame retardant, a colorant, an organic solvent, and a thermoplastic resin are exemplary examples.

(Thermosetting catalyst)

The resin composition according to the embodiment of the present invention may contain a thermosetting catalyst. The thermosetting catalyst is not particularly limited, and a known thermosetting catalyst can be appropriately used. The thermosetting catalyst contained in the resin composition according to the embodiment of the present invention may be one kind, a plurality of kinds thereof may be used.
As the thermosetting catalyst, compounds having a structure derived from imidazole; dicyandiamide; chain-like or cyclic tertiary amines; organic phosphorus compounds; quaternary phosphonium salts; diazabicycloalkenes such as organic acid salts; and the like are exemplary examples. In addition, organometallic compounds, quaternary ammonium salts, metal halides, and the like can also be used. As the organometallic compounds, zinc octylate, tin octylate, aluminum acetylacetone complex, and the like are exemplary examples.
Among these, from the viewpoint of heat resistance and adhesiveness, a compound having a structure derived from imidazole and/or dicyandiamide is preferable.
In addition, the proportion of the compound having a structure derived from imidazole and the dicyandiamide in the thermosetting catalyst is not particularly limited, but is preferably 30% by mass or more and more preferably 50% by mass or more.
In addition, when the compound having a structure derived from imidazole and the dicyandiamide are used in combination, the ratio thereof is not particularly limited.
As the compound having a structure derived from imidazole and the dicyandiamide, for example, 2,4-diamino-6-[2'-ethyl-4'-methylimidazolyl-(1')]-ethyl-s-triazine, 2-phenyl-4,5-dihydroxymethylimidazole, 2-methylimidazole, 2-phenylimidazole, 2-phenyl-4-methylimidazole, 1-cyanoethyl-2-phenylimidazole, 2,4-diamino-6-[2'-methylinudazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, dicyandiamide, and the like are exemplary examples.
The amount of the thermosetting catalyst in the resin composition is preferably 5% by mass or less, and more preferably 4% by mass or less with respect to the thermosetting resin. In addition, the lower limit thereof is not particularly limited, but is preferably 0.1% by mass or more and more preferably 0.5% by mass or more.
When the amount of the thermosetting catalyst is within the above-described range, it can be expected to improve shelf life by improving the heat resistance of the cured product and reducing reaction rate of the thermosetting resin during storage.
An average particle diameter of the thermosetting catalyst is not particularly limited, and an average particle diameter of at least one or more kinds of thermosetting catalysts is preferably 15 μm or less and more preferably 10 μm or less. In addition, it is preferably 1 nm or more, more preferably 10 nm or more, and still more preferably 100 nm or more. When the average particle diameter thereof is the above-described upper limit value or less, solubility of the thermosetting catalyst in the resin components tends to be improved and the reaction rate tends to be improved. In addition, the elastic modulus of the cured product sheet can be increased and a glass transition temperature tends to be increased. Furthermore, dispersibility of the thermosetting catalyst tends to be improved and storage stability tends to be improved. On the other hand, when the average particle diameter thereof is the above-described lower limit or more, secondary aggregation of the thermosetting catalyst itself is suppressed, the dispersibility of the thermosetting catalyst is improved, and the storage stability of the resin composition tends to be improved. In addition, the handleability of the resin composition during production tends to be favorable.

An average particle diameter of a plurality of thermosetting catalysts is not particularly limited, and may be within the above-described range.

(Curing agent)

The thermosetting resin according to the present invention may contain a curing agent. The curing agent is not particularly limited, and for example, a phenol resin, an acid anhydride having an aromatic skeleton or an alicyclic skeleton, a water additive of the acid anhydride, or a modified product of the acid anhydride is preferable. By using these preferred curing agents, it tends to be capable of obtaining a cured product sheet which has an excellent balance between heat resistance, moisture resistance, and electrical physical properties. The curing agent may be used alone, or a combination of two or more kinds thereof may be used.

The phenol resin used as the curing agent is not particularly limited. As specific examples of the phenol resin, phenol novolak, o-cresol novolak, p-cresol novolak, t-butylphenol novolak, dicyclopentadiencresol, poly(paravinylphenol), bisphenol A type novolak, xylylene-modified novolak, decalin-modified novolak, poly(di-o-hydroxyphenyl)methane, poly(di-m-hydroxyphenyl)methane, poly(di-p-hydroxyphenyl)methane, and the like are exemplary examples.

Among these, in order to further improve flexibility and flame retardancy of the resin composition, and to improve mechanical properties and heat resistance of the cured product sheet, a novolak type phenol resin having a rigid main chain skeleton or a phenol resin having a triazine skeleton is preferable. In addition, in order to improve flexibility of the resin composition and toughness of the cured product sheet, a phenol resin having an allyl group is preferable.

As commercially available products of the above-described phenol resin, MEH-8005, MEH-8000H, and NEH-8015 (all of which are manufactured by Meiwa Kasei Co., Ltd.); YLH903 (manufactured by Mitsubishi Chemical Corporation); LA-7052, LA-7054, LA-7751, LA-1356, and LA-3018-50P (all of which are manufactured by Dainippon Ink Co., Ltd.); PSM6200, PS6313, and PS6492 (manufactured by Gun Ei Chemical Industry Co., Ltd.) are exemplary examples.

The acid anhydride having an aromatic skeleton, the water additive of the acid anhydride, and the modified product of the acid anhydride, which are used as the curing agent, are not particularly limited. As specific examples thereof, SMA resin EF30 and SMA resin EF60 (both of which are manufactured by Sartmer Japan); ODPA-M and PEPA (both of which are manufactured by Manac Incorporated); RIKACID MTA-10, RIKACID TMTA, RIKACID TMEG-200, RIKACID TMEG-500, RIKACID TMEG-S, RIKACID TH, RIKACID MH-700, RIKACID MT-500, RIKACID DSDA, and RIKACID TDA-100 (all of which are manufactured by New Japan Chemical Co., Ltd.); EPICLON B4400 and EPICLON B570 (both of which are manufactured by Dainippon Ink and Chemicals); and the like are exemplary examples.

It is preferable that the acid anhydride having an alicyclic skeleton, the water additive of the acid anhydride, and the modified product of the acid anhydride are an acid anhydride having a polyalicyclic skeleton, a water additive of the acid anhydride, and a modified product of the acid anhydride; or an acid anhydride having an alicyclic skeleton, which is obtained by an additive reaction between a terpene-based compound and maleic anhydride, a water additive of the acid anhydride, and a modified product of the acid anhydride. As specific examples thereof, RIKACID HNA and RIKACID HNA-100 (both of which are manufactured by Shin Nihon Rika Co., Ltd.); Epicure YH306 and Epicure YH309 (both of which are manufactured by Mitsubishi Chemical Corporation); and the like are exemplary examples.

In 100% by mass of the resin components according to the present invention, the curing agent is contained in an amount of 0% to 70% by mass, and in particular, preferably 0% to 55% by mass, more preferably 0% to 40% by mass, still more preferably 0% to 30% by mass, and even more preferably 1% to 20% by mass. When the amount of the curing agent is the above-described lower limit or more, sufficient curing performance can be obtained, and when being the above-described upper limit or less, the reaction proceeds effectively, the crosslinking density can be improved, the strength can be increased, and the film-forming property can be improved.

Furthermore, when the thermosetting resin is the epoxy resin, the amount of a reactive group in the curing agent is not limited, and with respect to the amount of the epoxy group in the thermosetting resin, it may be 0 equivalent, preferably 0.05 equivalent or more, more preferably 0.1 equivalent or more, still more preferably 0.15 equivalent or more, and particularly preferably 0.2 equivalent or more. In addition, with respect to the amount of the epoxy group in the thermosetting resin, it is preferably 2 equivalent or less, more preferably 0.9 equivalent or less, still more preferably 0.6 equivalent or less, and particularly preferably 0.4 equivalent or less.

When the amount of the reactive group in the curing agent is the above-described lower limit value or more with respect to the amount of the epoxy group in the thermosetting resin, a decrease in curing speed is suppressed, the epoxy group is less likely to remain, and effects of improving the strength of the cured product sheet and suppressing hygroscopicity tend to be obtained. On the other hand, when being the above-described upper limit value or less, the elastic modulus of the cured product sheet tends to increase.

(Solvent)

For example, in order to improve coating properties when molding the cured product sheet through the coating step, the resin composition according to the embodiment of the present invention may contain an organic solvent.

As the organic solvent which can be contained in the resin composition according to the embodiment of the present invention, methyl ethyl ketone, cyclohexanone, propylene glycol monomethyl ether acetate, butyl acetate, isobutyl acetate, propylene glycol monomethyl ether, and the like are exemplary examples. These organic solvents may be used alone, or a combination of two or more kinds thereof may be used.

When the resin composition according to the embodiment of the present invention contains an organic solvent, a content thereof is appropriately determined according to the handleability of the resin composition at the time of producing the cured product sheet, the shape before curing, the drying conditions, and the like. When the resin composition according to the embodiment of the present invention is in a form of slurry to be used in the coating step described later, the organic solvent is preferably used so that a concentration of solid contents (all components other than the solvent) in the resin composition according to the embodiment of the present invention or in the resin composition according to the embodiment of the present invention, after adding the inorganic filler described later, is 10% to 90% by mass, particularly 40% to 80% by mass.

In addition, when the resin composition according to the embodiment of the present invention is in a form of a sheet which has undergone steps such as coating and drying, the organic solvent is preferably used so that the concentration of solid contents (all components other than the solvent) in the resin composition according to the embodiment of the present invention or in the resin composition according to the embodiment of the present invention, after adding the inorganic filler described later, is 95% by mass or more, particularly 98% by mass or more.

(Method for producing resin composition)

The resin composition according to the embodiment of the present invention can be obtained by uniformly mixing the inorganic filler, the thermosetting resin, and other components added as necessary, by stirring or kneading. For the mixing, for example, a general kneading device such as a mixer, a kneader, and a single-screw or twin-screw kneader can be used, and during the mixing, heating may be performed as necessary.

The mixing order of each blending component is also optional as long as there is no particular problem such as reaction and generation of precipitates, and for example, a method for producing a resin solution by mixing and dissolving the thermosetting resin component in an organic solvent (for example, methyl ethyl ketone), adding a material obtained by sufficiently mixing the inorganic filler and other components to the obtained resin solution and mixing, adding and mixing an organic solvent thereto for adjustment of viscosity, and adding and mixing the curing agent, a curing accelerator, and additives such as a dispersant is an exemplary example.

(Production of cured product sheet)

Methods for producing the above-described resin composition according to the embodiment of the present invention and the cured product sheet according to the embodiment of the present invention will be described with examples.

The cured product sheet can be produced by a normally used method. For example, the cured product sheet can be obtained by preparing the resin composition according to the embodiment of the present invention, molding the resin composition into a sheet shape, laminating the sheets with an appropriate thickness, and curing the laminate.

The resin composition can be obtained by uniformly mixing the inorganic filler, the thermosetting resin, and other components added as necessary, by stirring or kneading.

For the mixing, for example, a general kneading device such as a mixer, a kneader, and a single-screw or twin-screw kneader can be used, and during the mixing, heating may be performed as necessary.

The mixing order of each blending component is also optional as long as there is no particular problem such as reaction and generation of precipitates, and for example, a method for producing a resin solution by mixing and dissolving the thermosetting resin component in an organic solvent (for example, methyl ethyl ketone), adding a material obtained by sufficiently mixing the inorganic filler and other components to the obtained resin solution and mixing, adding and mixing an organic solvent thereto for adjustment of viscosity, and adding and mixing the curing agent, the thermosetting catalyst, and additives such as a dispersant is an exemplary example.

As a method of molding and curing the prepared resin composition into a sheet shape, a generally used method can be used.

As a method of molding the slurry-like resin composition into a sheet shape, it can be obtained by molding the resin composition into a sheet shape by a method such as a doctor blade method, a solvent casting method, and an extrusion film forming method.

The solvent in the resin composition can be removed by a known heating method such as a hot plate, a hot air furnace, an IR heating furnace, a vacuum dryer, and a high frequency heater.

Hereinafter, an example of a method for producing a cured product sheet using the slurry-like resin composition will be described.

<Coating step>

First, the slurry-like resin composition is applied to a surface of a base material to form a coating film (sheet-shaped resin composition).

That is, the slurry-like resin composition is used to form the coating film on the base material by a dip method, a spin coating method, a spray coating method, a blade method, or any other methods. A coating device such as a spin coater, a slit coater, a die coater, or a blade coater can be used for applying the slurry-like resin composition, and as a result, it is possible to uniformly form a coating film having a predetermined thickness on the base material.

As the base material, a copper foil and a PET film, which will be described later, are generally used, but are not particularly limited.

<Drying step>

In order to remove the solvent or low-molecular-weight components, the coating film formed by applying the slurry-like resin composition is usually dried at a temperature of 10°C to 150°C, preferably 25°C to 120°C and more preferably 30°C to 110°C. When the drying temperature is the above-described upper limit value or less, curing of the thermosetting resin in the slurry-like resin composition is suppressed, the resin in the sheet-shaped resin composition flows in the subsequent pressurization step, and the voids tend to be easily removed. In addition, when the drying temperature is the above-described lower limit value or more, the solvent can be effectively removed and productivity tends to be improved.

The drying time is not particularly limited, and can be appropriately adjusted depending on a state of the slurry-like resin composition, the drying environment, and the like. It is preferably 1 minute or more, more preferably 2 minutes or more, still more preferably 5 minutes or more, even more preferably 10 minutes or more, particularly preferably 20 minutes or more, and most preferably 30 minutes or more. On the other hand, it is preferably 4 hours or less, more preferably 3 hours or less, and still more preferably 2 hours or less.

When the drying time is the above-described lower limit or more, the solvent can be sufficiently removed, and a residual solvent tends to be suppressed from becoming voids in the cured product sheet. When the drying time is the above-described upper limit or less, the productivity tends to be improved and the production cost tends to be suppressed.

<Pressurization step>

After the drying step, in order to join the inorganic fillers to each other to form a heat path, to eliminate voids and cavities in the sheet, and to improve adhesion to the base material, it is desirable to perform a pressurization step on the obtained sheet-shaped resin composition. It is desirable that the pressurization step is performed by applying a weight of 2 MPa or more to the sheet-shaped resin composition on the base material. The weight is preferably 5 MPa or more and more preferably 10 MPa or more. In addition, it is preferably 2000 MPa or less and more preferably 1800 MPa or less.

When the weight during the pressurization is the above-described upper limit or less, it is possible to obtain a sheet having high thermal conductivity, in which secondary particles of the inorganic filler are not broken and the cavities are not generated in the cured product sheet. In addition, when the weight is the above-described lower limit or more, since contact between the inorganic fillers is favorable and the heat conduction path is easily formed, it is possible to obtain a cured product sheet having high thermal conductivity.

In the pressurization step, a heating temperature of the sheet-shaped resin composition on the substrate is not particularly limited. It is preferably 10°C or higher, more preferably 20°C or higher, and still more preferably 30°C or higher. In addition, it is preferably 300°C or lower, more preferably 280°C or lower, still more preferably 250°C or lower, even more preferably 100°C or lower, and particularly preferably 90°C or lower. By performing the pressurization step in this temperature range, a melt viscosity of the resin in the coating film can be lowered, and voids and cavities in the cured product sheet can be eliminated. In addition, by heating the sheet-shaped resin composition to the above-described upper limit value or lower, it tends to be capable of suppressing decomposition of organic components in the sheet-shaped resin composition and the cured product sheet, and suppressing the voids generated by the residual solvent.

The time of the pressurization step is not particularly limited. It is preferably 30 seconds or more, more preferably 1 minute or more, still more preferably 3 minutes or more, and particularly preferably 5 minutes or more. In addition, it is preferably 1 hour or less, more preferably 30 minutes or less, and still more preferably 20 minutes or less.

When the pressurization time is the above-described upper limit or less, it tends to be capable of reducing production time of the cured product sheet and reducing production cost. On the other hand, when the pressurization time is the above-described lower limit or more, it tends to be capable of sufficiently removing the cavities and voids in the cured product sheet, and improving heat transfer performance or withstand voltage characteristics.

<Curing step>

A curing step for completely carrying out the curing reaction of the resin composition according to the embodiment of the present invention may be performed under pressure or may be performed without pressure. In addition, the pressurization step and the curing step may be performed at the same time.

The applied pressure when the pressurization step and the curing step are performed at the same time is not particularly limited. The applied pressure to the sheet-shaped resin composition on the base material is preferably 3 MPa or more and more preferably 5 MPa or more. In addition, it is preferably 2000 MPa or less and more preferably 1800 MPa or less. When the applied pressure is the above-described upper limit or less, it is possible to obtain a sheet having high thermal conductivity, in which secondary particles of the inorganic filler are not broken and the cavities are not generated in the cured product sheet. In addition, when the applied pressure is the above-described lower limit or more, since contact between the inorganic fillers is favorable and the heat conduction path is easily formed, it is possible to obtain a cured product sheet having high thermal conductivity.

The pressurization time when the pressurization step and the curing step are performed at the same time is not particularly limited. It is preferably 30 seconds or more, more preferably 1 minute or more, still more preferably 3 minutes or more, and particularly preferably 5 minutes or more. In addition, it is preferably 8 hours or less, more preferably 6 hours or less, and still more preferably 4 hours or less. When the pressurization time is the above-described upper limit or less, it tends to be capable of reducing production time of the sheet-shaped cured product sheet and reducing production cost. On the other hand, when the pressurization time is the above-described lower limit or more, it tends to be capable of sufficiently removing the cavities and voids in the cured product sheet, and improving heat transfer performance or withstand voltage characteristics.

The heating temperature of the sheet-shaped resin composition on the substrate when the pressurization step and the curing step are performed at the same time is not particularly limited. It is preferably 10°C or higher, more preferably 20°C or higher, and still more preferably 30°C or higher. In addition, it is preferably 300°C or lower, more preferably 250°C or lower, still more preferably 200°C or lower, even more preferably 100°C or lower, and particularly preferably 90°C or lower. By setting this temperature range, a melt viscosity of the resin in the coating film can be lowered, and voids and cavities in the cured product sheet can be eliminated. In addition, by heating the sheet-shaped resin composition to the above-described upper limit value or lower, it tends to be capable of suppressing decomposition of organic components in the sheet-shaped resin composition and the cured product sheet, and suppressing the voids generated by the residual solvent.

A heating temperature of the sheet-shaped resin composition on the substrate when only the curing step is performed is not particularly limited. It is preferably 10°C or higher, more preferably 50°C or higher, and still more preferably 100°C or higher. In addition, it is preferably 500°C or lower, more preferably 400°C or lower, still more preferably 250°C or lower, even more preferably 180°C or lower, and particularly preferably 175°C or lower. By setting this temperature range, the curing reaction of the resin effectively proceeds. In addition, when the heating temperature is the above-described upper limit value or lower, thermal deterioration of the resin is prevented. Furthermore, when the heating temperature is the above-described lower limit or higher, the curing reaction of the resin proceeds more effectively.

The thickness of the cured product sheet obtained as above is not particularly limited, but is preferably 50 $\mu$m or more, more preferably 80 $\mu$m or more, and still more preferably 100 $\mu$m or more. In addition, it is preferably 400 $\mu$m or less and more preferably 300 $\mu$m or less. When the thickness of the cured product sheet is the above-described lower limit or more, withstand voltage characteristics are obtained and breakdown voltage tends to be improved. In addition, when the thickness of the cured product sheet is the above-described upper limit or less, it tends to be capable of achieving miniaturization and thinning of the device, and of suppressing the heat resistance of the obtained cured product sheet (heat dissipation sheet).

[Composite molded body]

In the composite molded body according to the embodiment of the present invention, a cured product part consisting of the cured product sheet according to the embodiment of the present invention and a metal part are laminated and integrated. The metal part may be provided on only one surface of the cured product part consisting of the cured product sheet according to the embodiment of the present invention, or may be provided on two or more surfaces thereof. For example, the cured product sheet may have the metal part on only one surface, or may have the metal part on both surfaces. In addition, the metal part may be patterned.

Such a composite molded body according to the embodiment of the present invention can be produced by, using the metal part as the above-described base material, forming the cured product sheet according to the embodiment of the present invention on the base material according to the method described above. In addition, it can also be produced by peeling off the sheet-shaped resin composition or the cured product sheet, which is formed on the base material different from the metal part, from the base material and then heat-pressing it onto a metal member to be the metal part.

In this case, the sheet-shaped resin composition or the cured product sheet according to the present invention is formed in the same manner as described above, except that it is applied onto the base material such as PET, which may be treated with a release agent, and then peeled off from the base material. Thereafter, the sheet-shaped resin composition or the cured product sheet is placed on another metal plate or interposed between two metal plates, and pressurized to be integrated.

In this case, as the metal plate, a metal plate having a thickness of approximately 10 $\mu$m to 10 cm and formed of copper, aluminum, nickel-plated metal, or the like can be used. In addition, a surface of the metal plate may be physically roughened or chemically treated with a surface treatment agent or the like, and it is more preferable that these treatments are performed from the viewpoint of adhesion between the resin composition and the metal plate.

[Semiconductor device]

The composite molded body according to the embodiment of the present invention can be used as a semiconductor device. In particular, the composite molded body according to the embodiment of the present invention can be usefully used in a power semiconductor device capable of increasing output and increasing density by operating at high temperatures.

Hereinafter, the present invention will be described in more detail with reference to Examples, but the present invention is not limited to the following Examples as long as the gist thereof is maintained. The various conditions and the values of the evaluation results in the following Examples indicate preferable ranges of the present invention as in the preferable range in the embodiment of the present invention, and the preferable range of the present invention can be determined in consideration of the preferable ranges in the embodiment described above and the range indicated by the values of the following Examples or a combination of values of Examples.

[Raw materials]

Raw materials used in Examples and Comparative Examples are as follows.

<Epoxy resin>

Resin component 1: difunctional epoxy resin disclosed as a resin component 1 in Japanese Unexamined Patent Application, First Publication No. 2020-63438

polystyrene-equivalent mass-average molecular weight: 30,000
weight per epoxide equivalent: 9,000 g/equivalent

Resin component 2: biphenyl type solid epoxy resin manufactured by Mitsubishi Chemical Corporation

molecular weight: approximately 400
weight per epoxide equivalent: 200 g/equivalent

Resin component 3: polyfunctional epoxy resin having a structure having four or more glycidyl groups per molecule, manufactured by Showa Denko K.K.

molecular weight: approximately 400
weight per epoxide equivalent: 100 g/equivalent

Resin component 4: polyfunctional epoxy resin having a structure having four or more glycidyl groups per molecule, manufactured by Nagase ChemteX Corporation

molecular weight: approximately 400

weight per epoxide equivalent: 100 g/equivalent

Resin component 5: Bis A type liquid epoxy resin manufactured by Mitsubishi Chemical Corporation

molecular weight: approximately 370
weight per epoxide equivalent: 190 g/equivalent

<Inorganic filler>

Inorganic filler A: boron nitride aggregated particles having a card-house structure, manufactured in accordance with the method for producing boron nitride aggregated particles disclosed in examples of PCT International Publication No. 2015/561028

average particle diameter: 45 μm
Inorganic filler B1 -1: spherical alumina particles manufactured by Admatechs average particle diameter: 7 μm (peak particle diameter: 15 μm, 0.6 μm) amount of spherical particles having a diameter of 0.1 to 1 μm: 13.5%
Inorganic filler B1-2: spherical alumina particles manufactured by Admatechs average particle diameter: 9 μm (peak particle diameter: 12 μm, 0.3 μm) amount of spherical particles having a diameter of 0.1 to 1 μm: 19.3%
Inorganic filler B1-3: spherical alumina particles manufactured by Admatechs average particle diameter: 0.2 μm amount of spherical particles having a diameter of 0.1 to 1 μm: 82.3%

<Curing agent>

Curing agent 1: "MEH-8000H" manufactured by Meiwa Kasei Co., Ltd. phenol resin-based curing agent

<Thermosetting catalyst>

Thermosetting catalyst 1: 2,4-diamino-6-[2'-ethyl-4'-methylimidazolyl-(1')]-ethyl-s-triazine; structure derived from imidazole, having both structures derived from triazine in one molecule ("CURESOL 2E4MZ-A" manufactured by SHIKOKU CHEMICALS CORPORATION)
Thermosetting catalyst 2: 2-phenyl-4,5-dihydroxymethylimidazole ("CURESOL 2PHZ-PW" manufactured by SHIKOKU CHEMICALS CORPORATION)

[Preparation, measurement, and evaluation of sample]

Preparation method, measuring conditions, and evaluation method of molded bodies in Examples and Comparative Examples are as follows.

<Example 1>

Using a rotating and revolving stirrer, a mixture was prepared by mixing the resin component 1, the resin component 2, the resin component 3, the curing agent 1, the thermosetting catalyst 1, the thermosetting catalyst 2, and the inorganic filler A so that a mass ratio described in Example 1 of Table 1 below was obtained. When preparing the mixture, 18.6% by mass of each of methyl ethyl ketone and cyclohexanone was used to prepare a slurry-like resin composition such that the mixture was 62.8% by mass (concentration of solid contents) as a coating slurry.
The obtained slurry-like resin composition was applied to a PET base material by a doctor blade method, dried by heating at 60°C for 120 minutes, and pressurized to obtain a sheet-shaped resin composition having a thickness of 150 μm. The total amount of methyl ethyl ketone and cyclohexanone in the sheet-shaped resin composition was 1% by mass or less.

[Measurement method]

<Measurement of weight per epoxide equivalent (WPE) of resin components>

A sample prepared by adjusting the resin components described in each of Examples and Comparative Examples at the mass ratio described in Tables 1 and 2 below was measured by a potential difference titration method, and the weight per epoxide equivalent was obtained by converting into the value of the entire resin component.

$100 \leq WPE \leq 300$ was evaluated as O, and the others were evaluated as X.

<Measurement of G' of cured product of resin components>

A sample prepared by adjusting the resin components described in each of Examples and Comparative Examples at the mass ratio described in Tables 1 and 2 below was applied onto a PET film, and dried by heating. Thereafter, using a rheometer "MCR302" manufactured by Anton Paar GmbH, the uncured resin component was cured by heating, and the storage rigidity (G') at 200°C was measured.

A parallel plate made of aluminum was used for the measurement, and the measurement conditions were a strain of 0.3%, a frequency of 1 Hz, and a gap of 0.5 mm.

The temperature profile during the heat curing started from 25°C, and the temperature was raised to 120°C at 14°C per minute and held for 30 minutes after reaching 120°C. Thereafter, the temperature was subsequently raised to 175°C at 7°C per minute, held for 30 minutes after reaching 175°C, further raised to 200°C at 7°C per minute, and held for 10 minutes after reaching 200°C. G' measured during the holding at 200°C for 10 minutes was used for the evaluation.

<Evaluation of handleability of sheet (cut test)>

Each of the resin compositions was prepared using the rotating and revolving stirrer in the same manner as in each of Examples and Comparative Examples, and a sheet obtained by heat-drying and pressure-molding was cut with scissors to evaluate handleability.

O: cut cross section was chipped, and no cracking was observed.

X: cut cross section was chipped, and cracking occurred.

<Measurement of E' of cured product of resin composition>

Each of the resin compositions was prepared using the rotating and revolving stirrer in the same manner as in each of Examples and Comparative Examples, and three sheets obtained by heat-drying and pressure-molding were laminated and cured by heating to obtain a cured product of the resin composition. Evaluation was carried out using a test piece cut out from the obtained cured product of the resin composition into a size of 4 mm wide and approximately 50 to 60 mm long. The measurement was carried out under the following conditions using "DMS6100" manufactured by Hitachi High-Tech Corporation as a measuring device.

Measurement temperature condition: -110°C to 270°C
Measurement mode: tensile mode
Measurement frequency: 1 Hz
Distance between chucks: 35 mm
Strain amplitude ($\mu$m): 5 $\mu$m
Strength amplitude initial value (mN): 50 mN

When E' at 270°C and 30°C satisfied the following requirement, it was evaluated as O, and when it did not satisfy the following requirement, it was evaluated as X.

$$1 \geq (E' \text{ at } 270°C)/(E' \text{ at } 30°C) \geq 0.2$$

<Measurement of thermal conductivity in thickness direction of resin composition layer>

Using a heat resistance measuring device (manufactured by Mentor Graphics, product name "T3ster"), thermal resistance values of cured products of resin compositions, having different thicknesses, having the same formulation, and produced under the same conditions, were measured, and the thermal conductivity $\lambda$ (W/m·K) was obtained from the slope of the graph plotting the thermal resistance value against the thickness.

<Measurement of breakdown voltage (BDV) of cured product of resin composition>

The resin composition was bonded to a 2 mm-thick copper plate by heat and pressure curing to produce a cured product of the resin composition on the copper plate, and evaluation was performed. The pressure was increased by 500 V every 1 minute in an insulating oil to obtain a voltage at which the cured product of the resin composition was broken.

<Examples 2 to 3 and Comparative Examples 1 to 5>

A sheet-shaped resin composition was obtained by adjusting the resin components in the same manner as in Example 1, except that each component was used to have the formulation shown in Tables 1 and 2. The measurement of WPE, the measurement of G' of the cured product of the resin components, the evaluation of the handleability of the sheet, the measurement of E' of the cured product of the resin composition, the measurement of the thermal conductivity, and the measurement of BDV were performed. The results of each of Examples and Comparative Examples are shown in Tables 1 and 2.

From the results of Examples, it was found that, by using a resin composition containing a specific filler and a resin as the resin composition according to the embodiment of the present invention, it was possible to obtain a cured product sheet with high thermal conductivity, high insulating property, and high heat resistance while maintaining handleability of an uncured sheet.

From the comparison between Examples 1 to 3 and Comparative Examples 1 and 2, it was found that high thermal conductivity was obtained when the proportion of the boron nitride aggregated filler was high. From the comparison between Example 1 and Comparative Example 3, it was found that, when the WPE of the resin components was in a predetermined range, the insulating property was improved even when the proportion of the boron nitride aggregated filler was high. It is speculated that, when the WPE was in a predetermined range, the resin fluidity was improved, the voids in the cured product sheet were reduced, and the crosslinking density was improved. From the comparison between Example 1 and Comparative Examples 3 and 4, it was found that, even when the proportion of the boron nitride aggregated filler was the same, by satisfying the range of $1 \geq (E'$ at 270°C)/($E'$ at 30°C) $\geq 0.2$, the spring back of the filler was suppressed and the thermal conductivity was increased. From the comparison between Example 1 and Comparative Example 5, it was found that the handleability of the sheet was increased by containing the epoxy resin having a mass-average molecular weight of 5,000 or more.

[Table 1]

| | | Example 1 | Example 2 | Example 3 | Comparative Example 1 | Comparative Example 2 | Comparative Example 3 | Comparative Example 4 | Comparative Example 5 |
|---|---|---|---|---|---|---|---|---|---|
| Inorganic filler (part by mass) | Inorganic filler A | 100 | 100 | 100 | 100 | 100 | 100 | 100 | 100 |
| | Inorganic filler B1-1 | | 22 | | 40 | 40 | | | |
| | Inorganic filler B1-2 | | | 10 | | | | | |
| | Inorganic filler B1-3 | | | | | | | | |
| | Inorganic filler B2-1 | | | | | | | | |
| Epoxy resin (part by mass) | Resin component 1 | 10 | 9 | 10 | 14 | 14 | 24 | 10 | 0 |
| | Resin component 2 | 16 | 15 | 17 | | | 4 | 0 | 14 |
| | Resin component 3 | 8 | | 8 | | | 8 | 0 | 4 |
| | Resin component 4 | | 8 | | 13 | 16 | 0 | 0 | 0 |
| | Resin component 5 | | | | 14 | 17 | 0 | 25 | 14 |
| Curing agent (part by mass) | Curing agent 1 | 6 | 5 | 6 | 14 | 9 | 4 | 5 | 7 |
| Thermosetting catalyst (part by mass) | Thermosetting catalyst 1 | 0.4 | 0.4 | 0.4 | 0.8 | 0.8 | 0.4 | 0.4 | 0.4 |
| | Thermosetting catalyst 2 | 0.4 | 0.4 | 0.4 | | | 0.4 | 0.4 | 0.4 |

EP 4 318 574 A1

(continued)

| | | Example 1 | Example 2 | Example 3 | Comparative Example 1 | Comparative Example 2 | Comparative Example 3 | Comparative Example 4 | Comparative Example 5 |
|---|---|---|---|---|---|---|---|---|---|
| Amount of inorganic filler in resin composition (solid contents) (% by volume) | Inorganic filler A | 57 | 55 | 55 | 44 | 44 | 57 | 57 | 57 |
| | Inorganic filler B1-1 | | 7 | | 10 | 10 | | | |
| | Inorganic filler B1-2 | | | 3 | | | | | |
| | Inorganic filler B1-3 | | | | | | | | |
| | Inorganic filler B2-1 | | | | | | | | |
| Proportion of boron nitride filler (A) in inorganic filler (% by volume) | | 100 | 89 | 95 | 81 | 81 | 100 | 100 | 100 |
| Proportion of spherical particles which is inorganic filler (B) other than boron nitride filler (A) and has average particle diameter of 0.1 $\mu$m or more and 1 $\mu$m or less, in inorganic filler (% by volume) | | | 1.5 | 1.0 | 2.5 | 2.5 | | | |

[Table 2]

| | | Example 1 | Example 2 | Example 3 | Comparative Example 1 | Comparative Example 2 | Comparative Example 3 | Comparative Example 4 | Comparative Example 5 |
|---|---|---|---|---|---|---|---|---|---|
| Evaluation | WPE of resin components [g/eq] | 255.3 | 255.3 | 255.3 | 272.54 | 225.08 | 390 | 291 | 210 |
| | | O | O | O | O | O | X | O | O |
| | G' of cured product of resin components [Pa] (30°C) | $1.9 \times 10^8$ | $1.9 \times 10^8$ | $1.9 \times 10^8$ | $1.8 \times 10^8$ | $1.7 \times 10^8$ | $2.1 \times 10^8$ | $2.0 \times 10^8$ | - |
| | G' of cured product of resin components [Pa] (200°C) | $6.4 \times 10^7$ | $6.4 \times 10^7$ | $6.4 \times 10'$ | $1.7 \times 10^7$ | $3.5 \times 10^7$ | $2.5 \times 10'$ | $9.1 \times 10^6$ | - |
| | G' ratio 200°C - G'/30°C - G' | 0.34 | 0.34 | 0.34 | 0.09 | 0.21 | 0.12 | 0.05 | - |
| | | O | O | O | X | O | O | x | - |
| | Handleability cut test | O | O | O | O | O | x | O | X |
| | E' of cured product of resin composition (30°C) | $1.80 \times 10^{10}$ | $2.40 \times 10^{10}$ | $1.20 \times 10^{10}$ | $1.20 \times 10^{10}$ | $1.40 \times 10^{10}$ | $1.52 \times 10^{10}$ | $1.57 \times 10^{10}$ | $1.46 \times 10^{10}$ |
| | E' of cured product of resin composition (270°C) | $5.20 \times 10^9$ | $7.20 \times 10^9$ | $4.30 \times 10^9$ | $3.40 \times 10^9$ | $2.60 \times 10^9$ | $2.72 \times 10^9$ | $2.87 \times 10^9$ | $4.32 \times 10^9$ |
| | E' ratio 270°C - E'/30°C - E' | O | O | O | O | X | X | X | O |
| | $\lambda$ [W/mK] | is | 19 | 18 | 14 | 14 | 6.87 | 16 | *- |
| | BDV [kV/mm] | 64 | 47 | 64 | 47 | 47 | 10 | 46 | 51 |

In "*" of Table 2, the sheet (cured product of the resin composition) was brittle in the thermal conductivity measurement, and a sample for performance evaluation could not be produced.

**Claims**

1. A resin composition comprising:

   an inorganic filler; and
   a thermosetting resin,
   wherein an amount of the inorganic filler in solid contents of the resin composition is 50% by volume or more, and the inorganic filler contains 82% by volume or more of a boron nitride filler (A),
   the boron nitride filler (A) includes an aggregated filler,
   the thermosetting resin contains an epoxy resin having a mass-average molecular weight of 5,000 or more,
   a weight per epoxide equivalent (WPE) of resin components in the resin composition satisfies $100 \leq WPE \leq 300$, and
   a storage modulus E' of a cured product of the resin composition satisfies $1 \geq (E'$ at 270°C)/(E' at 30°C) $\geq 0.2$.

2. The resin composition according to Claim 1,
   wherein a rigidity G' of a cured product of the resin components satisfies $1 \geq (G'$ at 200°C)/(G' at 30°C) $> 0.1$.

3. The resin composition according to Claim 1 or 2,
   wherein the storage modulus E' of the cured product of the resin composition is $1 \times 10^8$ Pa or more at 30°C.

4. The resin composition according to any one of Claims 1 to 3,

   wherein the inorganic filler contains an inorganic filler (B) other than the boron nitride filler (A),
   the inorganic filler (B) contains spherical particles having an average particle diameter of 0.1 $\mu$m or more and 1 $\mu$m or less, and
   a proportion of the spherical particles having an average particle diameter of 0.1 $\mu$m or more and 1 $\mu$m or less in the inorganic filler is 2.4% by volume or less.

5. The resin composition according to any one of Claims 1 to 4,
   wherein the thermosetting resin has an epoxy resin having a mass-average molecular weight of 10,000 or more and an epoxy resin having a mass-average molecular weight of 600 or less.

6. The resin composition according to Claim 5,
   wherein the epoxy resin having a mass-average molecular weight of 600 or less includes three or more epoxy groups in one molecule.

7. The resin composition according to any one of Claims 1 to 6,
   wherein the inorganic filler (B) is a metal oxide and/or a non-metal oxide.

8. A cured product sheet formed of the resin composition according to any one of Claims 1 to 7.

9. A composite molded body comprising:

   a cured product part comprising the cured product sheet according to Claim 8; and
   a metal part.

10. A semiconductor device comprising:
    the composite molded body according to Claim 9.

## INTERNATIONAL SEARCH REPORT

| | International application No. |
|---|---|
| | **PCT/JP2022/015374** |

**A. CLASSIFICATION OF SUBJECT MATTER**

*H01L 23/373*(2006.01)i; *C08K 7/18*(2006.01)i; *C08L 63/00*(2006.01)i; *C08K 3/38*(2006.01)i
FI: C08L63/00 C; C08K3/38; C08K7/18; H01L23/36 M

According to International Patent Classification (IPC) or to both national classification and IPC

**B. FIELDS SEARCHED**

Minimum documentation searched (classification system followed by classification symbols)

H01L23/373; C08K7/18; C08L63/00; C08K3/38

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2018-188628 A (SEKISUI CHEM. CO., LTD.) 29 November 2018 (2018-11-29) claims, paragraphs [0003], [0010], [0024], [0048], [0067], [0070], [0101], examples | 1-10 |
| A | JP 2017-36415 A (MITSUBISHI CHEMICALS CORP.) 16 February 2017 (2017-02-16) | 1-10 |
| A | JP 2015-6980 A (MITSUBISHI CHEMICALS CORP.) 15 January 2015 (2015-01-15) | 1-10 |
| A | WO 2019/189746 A1 (MITSUBISHI CHEMICAL CORP.) 03 October 2019 (2019-10-03) | 1-10 |
| A | WO 2015/119198 A1 (MITSUBISHI CHEMICALS CORP.) 13 August 2015 (2015-08-13) | 1-10 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **06 June 2022** | **21 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/015374**

| Patent document cited in search report | | | Publication date (day/month/year) | Patent family member(s) | | | Publication date (day/month/year) |
|---|---|---|---|---|---|---|---|
| JP | 2018-188628 | A | 29 November 2018 | (Family: none) | | | |
| JP | 2017-36415 | A | 16 February 2017 | (Family: none) | | | |
| JP | 2015-6980 | A | 15 January 2015 | (Family: none) | | | |
| WO | 2019/189746 | A1 | 03 October 2019 | US | 2020/0407618 | A1 | |
| | | | | EP | 3780089 | A1 | |
| | | | | CN | 111868921 | A | |
| WO | 2015/119198 | A1 | 13 August 2015 | EP | 3103766 | A1 | |
| | | | | CN | 106029561 | A | |
| | | | | KR | 10-2016-0117472 | A | |

Form PCT/ISA/210 (patent family annex) (January 2015)

## REFERENCES CITED IN THE DESCRIPTION

**Patent documents cited in the description**

- JP 2021055114 A
- JP 2013089670 A
- JP 2015006985 A
- JP 2016135730 A
- JP 2015119198 W
- JP 2017036415 A
- JP 2019189746 W
- JP 2020063438 A
- JP 2015561028 W